Europäisches Patentamt

European Patent Office

Office européen des brevets

(11) Numéro de publication: **0 225 814**

**A1**

# DEMANDE DE BREVET EUROPEEN

(21) Numéro de dépôt: **86402294.2**

(22) Date de dépôt: **15.10.86**

(51) Int. Cl.⁴: **G 01 N 24/06**
**H 01 F 7/20**

(30) Priorité: **18.10.85 FR 8515511**

(43) Date de publication de la demande:
**16.06.87 Bulletin 87/25**

(84) Etats contractants désignés: **DE GB NL**

(71) Demandeur: **THOMSON-CGR**
**13, square Max-Hymans**
**F-75015 Paris (FR)**

(72) Inventeur: **Prevot, Claude**
**THOMSON-CSF SCPI 19, avenue de Messine**
**F-75008 Paris (FR)**

**Rigeade, Bernard**
**THOMSON-CSF SCPI 19, avenue de Messine**
**F-75008 Paris (FR)**

**Miscopein, Jean**
**THOMSON-CSF SCPI 19, avenue de Messine**
**F-75008 Paris (FR)**

(74) Mandataire: **Grynwald, Albert et al**
**THOMSON-CSF SCPI 19, avenue de Messine**
**F-75008 Paris (FR)**

(54) **Bobine de gradient pour appareils d'imagerie par résonance magnétique nucléaire.**

(57) Dans l'invention la bobine de gradient est réalisée en quatre arrangements identiques et symétriques par rapport au centre d'un espace prédéterminé d'examen. Ces arrangements comportent des conducteurs (15-22) formés en selle de cheval. Dans une réalisation particulière pour chaque arrangement deux groupes (15-18, 19-22) de conducteurs sont prévus. Ils peuvent être par ailleurs superposés. Dans l'invention les conducteurs sont des conducteurs plats. D'une manière préférée leur section est rectangulaire (e × l), le grand côté étant supérieur ou égal à deux fois et demie le petit côté. Le choix de conducteurs plats permet de réduire la self-inductance du système ainsi construit. En définitive c'est la puissance nécessaire d'attaque pour l'établissement d'un gradient de champ qui s'en trouve réduite. La tenue en température de l'ensemble de l'appareil s'en trouve améliorée.
Applications : imagerie de type médical.

FIG_3-a

FIG_3-b

EP 0 225 814 A1

**Description**

BOBINE DE GRADIENT POUR APPAREILS D'IMAGERIE PAR RESONANCE MAGNETIQUE NUCLEAIRE

La présente invention a pour objet une bobine de gradient pour appareils d'imagerie par résonance magnétique nucléaire. Elle trouve plus particulièrement son application dans le domaine médical où l'imagerie par résonance magnétique nucléaire est unanimement reconnue comme aide aux diagnostics. Elle peut bien entendu être mise en oeuvre dans d'autres domaines. Le but de la présente invention est de concourir à la création d'images d'un corps à examiner plus fidèles ainsi que plus précises dans leur résolution

Un appareil d'imagerie par résonance magnétique nucléaire comporte essentiellement trois types de bobines. Un premier type de bobines (qui peut éventuellement être remplacé par un aimant permanent) a pour objet de créer un champ homogène intense $B_o$ dans un espace prédéterminé. Un deuxième type de bobines. dites radiofréquence. a pour but de soumettre un corps examiné et placé sous l'influence du champ des premières bobines à des séquences d'excitation radiofréquence, et de mesurer un signal radiofréquence réémis en retour par des particules du corps. La réponse radiofréquence est une réponse en volume : toutes les particules d'une région du corps soumise à l'examen émettent en même temps leur réponse radiofréquence. Pour créer l'image il est nécessaire de différencier ces réponses. A cette fin, les appareils d'imagerie comportent un troisième type de bobines, dites de gradient, pour superposer au champ intense des composantes de champ supplémentaires. La valeur de ces composantes est une fonction des coordonnées dans l'espace du lieu de leur application. Classiquement il est proposé d'organiser cette différenciation selon trois axes orthogonaux X, Y, Z. Par convention. l'axe Z est généralement colinéaire au champ intense créé par le premier type de bobines. Autrement dit, chaque lieu de l'espace peut être codé par une valeur de champ différente : on exploite dans le signal réémis les modifications qui en découlent.

Les bobines de gradient sont en conséquence réparties en trois familles : celle qui crée un gradient selon X, celle qui crée un gradient selon Y, et celle qui crée un gradient selon Z. L'invention a plus particulièrement pour objet de proposer une amélioration à la réalisation des deux premières familles. Un gradient de champ selon X est un champ magnétique dont la distribution de l'amplitude de la composante colinéaire au champ intense (Z). dans l'espace, est fonction uniquement de la coordonnée $x_i$ de son lieu d'application. Dans la pratique elle y est même simplement proportionnelle. Ceci signifie que toutes les particules d'un corps à examiner situées dans un plan parallèle à Y - Z et d'abscisse donnée $x_i$ sont soumises à un champ total $B_0 + G_x . x_i$. Le gradient $G_x$ est la pente de la variation de la composante selon Z du champ supplémentaire apporté par ces bobines de gradient X.

L'acquisition d'une image nécessite au cours de l'application des séquences d'excitation. l'application conjointe de séquences de gradient de champ. Les séquences de gradient de champ dépendent du procédé d'imagerie mis en oeuvre. Ce procédé peut par exemple être du type 2 DFT mis au point par MM. A. KUMAR et R.R. ERNST ou par exemple du type rétroprojection mis au point par M. P.C. LAUTERBUR. Quelle que soit la méthode d'imagerie retenue, la particularité des gradients de champ est qu'ils sont pulsés. Ils sont établis, ils persistent pendant une durée courte, puis ils sont coupés. Ceci peut advenir une ou plusieurs fois pendant chaque séquence. Cette particularité a pour conséquence que le fonctionnement des bobines du troisième type doit être étudié non seulement en régime permanent, pendant l'application des gradients. mais encore pendant les transitoires résultant de leur établissement et de leur coupure. Une autre particularité des gradients de champ concerne leur homogénéité. Par homogénéité on entend le respect, avec une tolérance donnée, et pour un gradient de champ réel, d'une distribution théorique idéale que l'on voudrait imposer. En effet les inhomogénéités ont pour conséquence de fausser la différenciation que l'on cherche à imposer dans l'espace et qui est la base même du principe de l'imagerie. De ce point de vue les problèmes d'homogénéité doivent être aussi bien résolus pour les gradients qu'ils peuvent l'être pour le champ homogène intense. La solution des problèmes créés par les transitoires se résoud en principe en réalisant des troisièmes types de bobines les plus petites possible. Plus elles sont petites. plus leur self-inductance est petite, et moins la puissance à fournir pour produire le champ est importante. Par contre pour l'homogénéité, plus les bobines sont grandes et plus la distribution des champs qu'elles produisent peut être considérée comme homogène. Ces deux tendances sont donc contradictoires. En général les bobines de gradient sont placées à l'extérieur et le plus près possible des bobines radiofréquence. Celles-ci déterminent en leur intérieur le volume d'examen ou est placé le corps.

Il est connu dans l'état de la technique, en particulier dans une demande de brevet européen n° 82 107 453.1 déposée le 16 août 1982, de telles bobines de gradient. Ces bobines comportent des conducteurs formés autour d'un cylindre selon un contour dit en selle de cheval. Les bobines de l'invention sont du même type mais présentent des particularités propres à résoudre au mieux le double problème de l'homogénéité et de la puissance électrique à mettre en oeuvre pour créer des gradients de champ. à partir de bobines de gradient dont la place est fixée à l'extérieur d'un cylindre donné et correspondant à un tunnel d'accès prévu pour y introduire les corps à examiner.

Dans l'invention on a appliqué une méthodologie originale de calcul des bobines de gradient et on a découvert une particularité des conducteurs de ces bobines qui permet de résoudre efficacement un problème de self minimale. et donc de puissance d'alimentation, alors que les conducteurs sont au départ dimensionnés pour produire un gradient le plus fort et le plus homogène possible. On peut par exemple montrer qu'avec les conducteurs de l'invention. a intensité et homogénéité du champ comparables, la puissance électrique à mettre en oeuvre est inférieure d'environ 20 % aux solutions classiques.

La présente invention a pour objet une bobine de gradient pour appareil d'imagerie par résonance magnétique nucléaire du type comportant des conducteurs formés chacun autour d'un cylindre selon un contour dit en selle de cheval, ces conducteurs étant rassemblés en quatre arrangements identiques et symétriques par rapport au centre d'un espace prédéterminé d'examen, caractérisée en ce que les conducteurs sont plats, leur section étant en forme de rectangle allongé, la petite dimension du rectangle étant orientée radialement au cylindre, le rapport de la grande dimension à la petite dimension étant supérieur ou égal à 2,5.

L'invention sera mieux comprise à la lecture de la description qui suit et à l'examen des figures qui l'accompagnent. Elles ne sont données qu'à titre indicatif et nullement limitatif de l'invention. Sur les figures les mêmes repères désignent les mêmes éléments. Elles montrent :
- Figure 1 : l'allure générale d'une bobine de gradient d'un appareil d'imagerie ;
- Figure 2 : une représentation schématique d'un tracé de conducteur mis en oeuvre dans l'invention ;
- Figures 3a et 3b : une vue de dessus et une vue en coupe d'une réalisation préférée d'un détail d'une bobine de gradient selon l'invention.

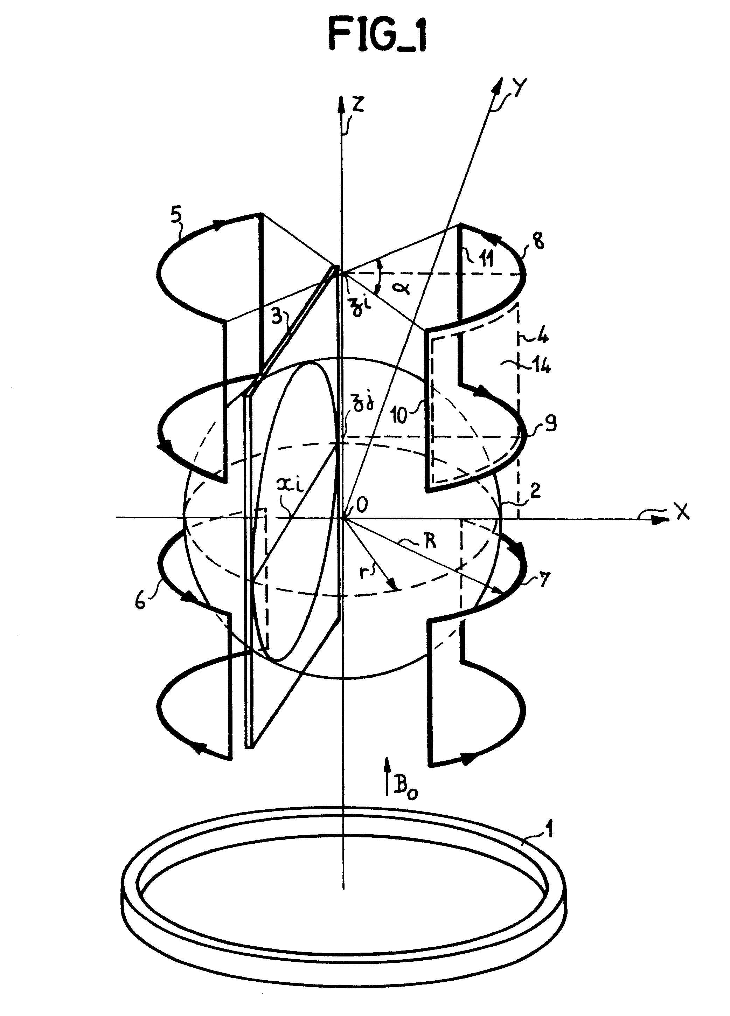

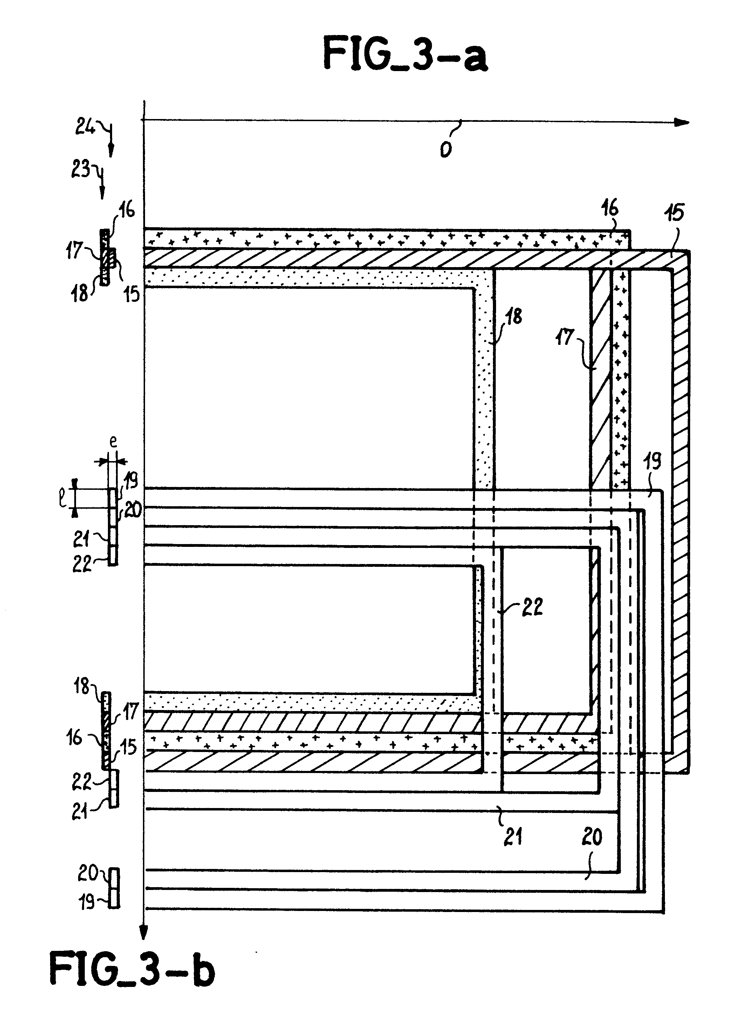

La figure 1 représente une bobine de gradient pour un appareil d'imagerie par résonance magnétique nucléaire. Cet appareil est symbolisé par une une bobine 1 du premier type qui produit un champ intense $B_0$ orienté selon un axe Z. Cet appareil comprend encore des bobines d'excitation radiofréquence non réprésentées. En général ces bobines radiofréquence sont réparties sur un cylindre circulaire centré sur l'axe Z. Elles ont pour objet d'exciter avec une excitation radiofréquence les particules d'un corps à imager qui se trouverait, au moins en partie, à l'intérieur d'un espace prédéterminé d'examen repéré par une sphère 2. La bobine de gradient représentée est prévue pour produire dans des tranches planes 3 repérées par leur abscisse $x_i$ (c'est-à-dire parallèles au plan Y-Z) des champs magnétiques supplémentaires dont la composante orientée parallèlement à Z est fonction de l'abscisse $x_i$. Cette bobine comporte quatre arrangements de conducteurs notés 4 à 7. Ces arrangements sont symétriques par rapport au centre O de la sphère 2. Ces arrangements de conducteurs symbolisés ici par le tracé à chaque fois d'un seul conducteur, sont également symétriques les uns des autres par rapport à un plan X-Y perpendiculaire à l'orientation du champ intense au centre du volume 2. Les conducteurs sont dessinés selon un contour dit en selle de cheval. Chaque contour comporte deux parties en arceau formées autour d'un cylindre et reliées entre elles à leurs extrémités par deux parties colinéaires aux génératrices de ce cylindre. Par exemple pour l'arrangement 4 il s'agit des arceaux 8 et 9 et des segments de génératrice 10 et 11. Les conducteurs des arrangements sont bien entendu parcourus par des courants de sens convenable pour produire le gradient recherché. Chaque conducteur d'un arrangement est défini par l'angle d'ouverture $\alpha$ de la portion du cylindre qu'il décrit, et par les altitudes $z_i$ et $z_j$ des extrémités des segments de génératrice qu'il comporte.

Compte tenu d'impératifs technologiques, l'encombrement des bobines radiofréquence et des protections associées a conduit à retenir, pour une sphère d'examen de rayon $\underline{r}$, un cylindre circulaire décrit par les arrangements de rayon R plus grand que $\underline{r}$. Dans un exemple R vaut sensiblement 1,6 r. Ceci étant, on divise dans un programme de calcul un conducteur théorique paramétré par le rayon R du cylindre qui le porte, ses coordonnées $z_i$ et $z_j$ et son ouverture angulaire $\alpha$, en un certain nombre de segments élémentaires consécutifs. On calcule pour chaque lieu de l'espace 2 la contribution de champ magnétique apportée par chaque segment de ce conducteur théorique quand il est parcouru par un courant I. En faisant la somme des contributions locales, on peut calculer en chaque lieu de l'espace d'intérêt le champ supplémentaire qui en découle. En faisant un calcul similaire, obtenu en fait par de simples opérations de symétrie, on peut connaître pour les mêmes lieux de l'espace 2 les contributions apportées par les petits segments correspondant des trois autres arrangements de la bobine de gradient. On calcule alors la composante du champ magnétique supplémentaire apportée par cette bobine de gradient et qui est orientée selon l'axe Z. La structure représentée sur la figure 1 est connue pour être adaptée à produire des champs supplémentaires dont la composante orientée selon Z varie en fonction de l'abscisse $x_i$. Pour une bobine de gradient produisant un champ supplémentaire dont la composante orientée selon Z varierait avec l'ordonnée $y_i$ on réalise un même type de bobine que l'on tourne tout simplement de 90° dans l'espace autour de l'axe Z.

A ce stade, sans se précoccuper de l'homogénéité, on détermine la forme la plus efficace de la selle de cheval qui donne le gradient le plus grand pour un courant I donné. On détermine ainsi une selle théorique dite productrice du gradient. On a découvert que ce résultat était atteint pour $z_j$, l'altitude de l'arceau le plus près du centre O de la sphère d'examen, sensiblement égal à 0,29 R. De la même façon $z_i$, l'altitude de l'arceau le plus éloigné du centre O, vaut sensiblement 1,27 R, l'angle $\alpha$ le plus favorable valant de l'ordre de 135°. On évalue alors l'écart entre les gradients ainsi obtenus en chaque lieu de la sphère 2 et les gradients théoriques qu'on aurait voulu y installer. On dresse ensuite une cartographie des écarts. On obtient en quelque sorte un relief d'écart. On peut présenter cette cartographie en une série de cartes correspondant à des plans, parallèles à un plan donné et espacés les uns des autres régulièrement. Dans un exemple les plans choisis sont parallèles au plans X-Y qui lui-même est appelé le plan zéro. A ce stade de la méthode on discrimine dans les reliefs d'écart les régions de l'espace où la tolérance d'homogénéité se trouve hors d'un domaine de tolérance choisi. On apporte alors une compensation à ces défauts par ajout d'une autre selle de cheval parcourue par un courant I' dont on dresse également la cartographie des écarts et dont on met en évidence le relief d'inhomogénéité de telle façon que ce relief vienne compenser le relief de la première. On a alors abouti à une autre selle de cheval, elle aussi théorique et dite correctrice d'homogénéité où les coordonnées

3

correspondantes $z'_j$, $z'_i$ et $\alpha'$ valent respectivement 0,85 R, 1,50 R, et également 135°.

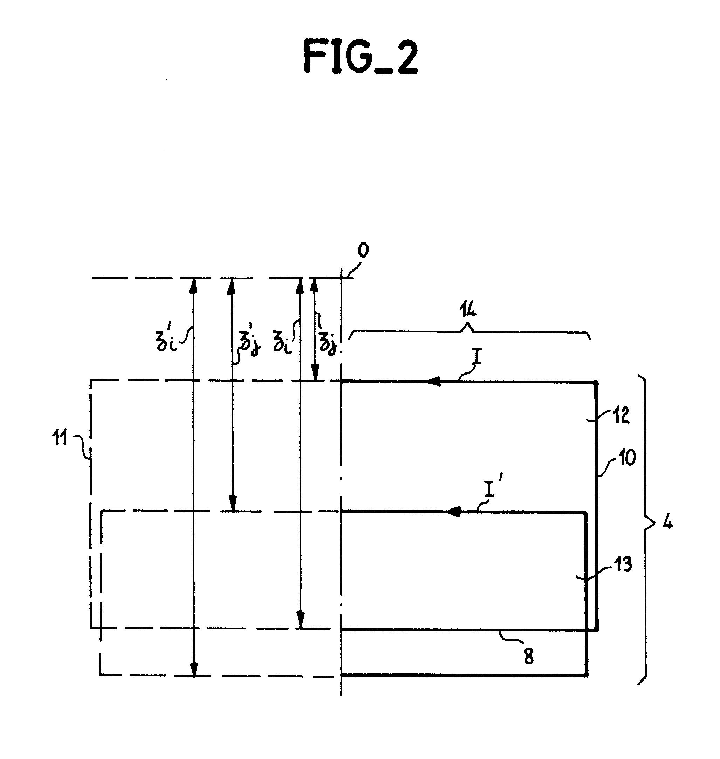

La question de l'homogénéité étant ainsi résolue on s'attache alors à réduire le plus possible la puissance à dissiper dans les conducteurs et qui est nécessaire à la mise en place du champ supplémentaire. On a découvert alors que la meilleure solution consistait à choisir des conducteurs plats. La section rectangulaire des conducteurs est même telle que le rapport de la grande dimension à la petite dimension de la section vaut d'une manière préférée 3,2. Un conducteur plat offre en plus un avantage : celui de pouvoir être facilement superposé à un autre conducteur. En effet la structure théorique élaborée jusqu'ici montre que de telles superpositions doivent nécessairement se produire. La figure 2 montre comment, une fois déployés dans un plan, se présentent les conducteurs théoriques calculés. Les ouvertures angulaires sont les mêmes pour les deux selles. Les sens des courants I et I' sont les mêmes dans la selle productrice 12 et dans la selle correctrice 13. Le fait de retenir les conducteurs plats est favorable à la superposition puisque que la puissance dissipée pour installer les gradients de champ croît avec la puissance 5 du rayon R du cylindre. Avec des conducteurs plats, à la superposition, l'augmentation du rayon R est réduite.

Pour le calcul de la self totale de la bobine on a calculé l'inductance externe aux conducteurs, comme il est connu de le faire classiquement. Mais dans l'invention on a aussi calculé l'inductance interne, c'est-à-dire l'inductance qui résulte du fait que chaque conducteur baigne également dans son propre champ. Le calcul de l'inductance globale a conduit à choisir des conducteurs plats. Ce calcul d'inductance globale conduit peu à peu à retenir la meilleure disposition des conducteurs réels, c'est-à-dire considération prise de leur dimension effective. Alors que pour le calcul du gradient du champ, chaque conducteur avait été remplacé par un fil sans dimension, le calcul de la self minimale du circuit est maintenant effectué en tenant compte des dimensions réelles.

L'étude menée pour déterminer le choix de la section optimale des conducteurs permet par ailleurs de placer exactement les conducteurs les uns par rapport aux autres autour de la position théorique (figure 2) qu'ils doivent prendre. En effet, compte tenu des contraintes de gradient de champ à mettre en oeuvre, typiquement de l'ordre de 0,8 Gauss par cm, et des ampères-tours nécessaires, de l'ordre de 800 à 1600 ampères-tours, il est hors de question de prévoir un seul conducteur. Dans un exemple où un courant de l'ordre de 200 ampères est disponible au sortir de moyens d'alimentation en courant, on est conduit à multiplier les conducteurs dans chaque arrangement. En multipliant les conducteurs, on dispose alors de paramètres supplémentaires ($z_i$, $z_j$, $\alpha$) liés à ces conducteurs qui permettent d'améliorer l'homogénéité du champ tout en conservant une self minimale au circuit.

Les figures 3a et 3b donnent un aperçu d'une solution préférée où la selle productrice comporte quatre conducteurs 15 à 18 (en selle de cheval) et où la selle correctrice du champ comporte également quatre conducteurs 19 à 22. Chaque conducteur y est traversé, pour simplifier, par un même courant. Dans un exemple, ce courant vaut 200 ampères. Cette particularité est mise à profit pour alimenter tous les conducteurs en série. Un tel raccordement en série est classique, de même que l'alimentation. Ils ne sont pas représentés ici pour clarifier le dessin. La figure 2 représente une développée d'un huitième d'arrangement coté 14 sur la figure 1. Celui-ci est représenté par ailleurs par la figure 3a. Cette représentation au huitième est préférée, elle permet de bien reconnaître les positions respectives des conducteurs. Par symétrie autour d'un plan passant par l'axe Z et par les milieux des secteurs cylindriques $\alpha$ décrits par les selles de cheval on peut déduire le reste de la forme des selles. Sur la figure 2 la représentation au huitième est même dessinée en tirets.

Les conducteurs producteurs déterminent des surfaces de selle de cheval plus grandes que celles des conducteurs correcteurs. Ils sont par ailleurs placés plus près du plan zéro dont la trace apparaît en haut de la figure. De plus, du fait des recouvrements nécessaires, les conducteurs correcteurs, dont l'influence en production est moindre, sont placés plus loin du plan zéro en une nappe superposée, dans la mesure du possible, à une nappe inférieure qui contient les conducteurs producteurs. La figure 3b montre bien en coupe les sections des conducteurs d'épaisseur $e$ et de largeur $l$ selon l'invention. Dans un exemple préféré, les conducteurs sont en cuivre, l'épaisseur vaut 5 mm et la largeur vaut 16 mm. L'épaisseur est disposée radialement au cylindre. Le cylindre porte les conducteurs selon deux nappes, une première nappe 23 et une deuxième nappe directement superposée 24. Si on appelle R le rayon du cylindre qui porte les conducteurs, dans un exemple préféré les ouvertures angulaires et les altitudes $z_j$ et $z_i$ de chacun des conducteurs sont données dans le tableau suivant :

| 15 | 150°00' | 0,291 R | 1,332 R |
|----|---------|---------|---------|
| 16 | 137°18' | 0,250 R | 1,291 R |
| 17 | 132°42' | 0,291 R | 1,250 R |
| 18 | 105°00' | 0,332 R | 1,209 R |
| 19 | 145°24' | 0,790 R | 1,621 R |
| 20 | 137°18' | 0,831 R | 1,580 R |
| 21 | 132°42' | 0,872 R | 1,415 R |
| 22 | 105°00' | 0,914 R | 1,374 R |

Ces paramètres sont susceptibles de variation de l'ordre de ± 10 % sans affecter notablement l'intérêt de l'invention. Cette variation peut notamment résulter d'un choix de conducteurs encore plus plats (d'épaisseur moitiée) et occupant plus de place à l'intérieur les uns des autres, en étant adjacents, dans leurs selles respectives.

On remarque que les conducteurs 16 et 20, 17 et 21 et 18 et 22 ont respectivement les mêmes ouvertures angulaires. Sur la figure 3a cependant leurs images ne sont pas superposées. Cette disposition résulte du fait que les deuxièmes cités sont situés sur une nappe radialement plus extérieure et donc dont le développement est plus grand.

Le choix des conducteurs plats montre tout son intérêt. Les conducteurs sont directement superposés selon des segments de génératrice du cylindre, c'est-à-dire là ou cela n'a aucune influence sur le gradient de champ, et sont au contraire le plus possible posés les uns à côté des autres dans les segments en arceau des selles. La réalisation proprement dite des conducteurs selon les formes indiquées sur la figure 3 est obtenue par des voies traditionnelles. On les réalise d'abord à plat. On les forme ensuite en selle de cheval autour d'un cylindre. Compte tenu de ce qui précède le rapport préféré de e à R vaut entre 0,5 % et 3 %. Typiquement il vaut 1 %. Les conducteurs sont isolés les uns des autres soit par une pellicule de vernis, soit par tout autre moyen.

**Revendications**

1. Bobine de gradient pour appareil d'imagerie par résonance magnétique nucléaire du type comportant des conducteurs (15-22) formés chacun autour d'un cylindre selon un contour dit en selle de cheval, ces conducteurs étant rassemblés en quatre arrangements (4-7) identiques et symétriques par rapport au centre (0) d'un espace (2) prédéterminé d'examen, caractérisée en ce que les conducteurs sont plats (fig 3b), leur section étant en forme de rectangle allongé, la petite dimension (e) du rectangle étant orientée radialement au cylindre, le rapport de la grande dimension à la petite dimension étant supérieur ou égal à 2,5.

2. Bobine suivant la revendication 1, caractérisée en ce qu'elle comporte des conducteurs répartis selon deux nappes (23, 24).

3. Bobine selon la revendication 1 ou 2, caractérisée en ce que chaque arrangement comprend un premier groupe (15-18) de conducteurs dit producteur du champ et un deuxième groupe (19-22) de conducteurs dit correcteur du champ, les conducteurs de chaque groupe étant traversés par un même courant, les conducteurs du deuxième groupe étant plus éloignés de l'espace d'examen que ne le sont les conducteurs du premier groupe, le flux produit par le deuxième groupe étant inférieur au flux produit par le premier.

4. Bobine selon l'une quelconque des revendications 1 à 3, caractérisée en ce que les quatre arrangements comportent huit conducteurs chacun, les huit conducteurs étant définis dans chaque arrangement par leurs paramètres d'ouverture angulaire et de position axiale des parties en arceau de la selle de cheval qu'ils forment, ces paramètres valant respectivement, à 10 % près en plus ou en moins :

| pour le premier conducteur | 150°00' | 0,291 R | 1,332 R |
|---------------------------|---------|---------|---------|
| pour le deuxième conducteur | 137°18' | 0,250 R | 1,291 R |
| pour le troisième conducteur | 132°42' | 0,291 R | 1,250 R |
| pour le quatrième conducteur | 105°00' | 0,332 R | 1,209 R |
| pour le cinquième conducteur | 145°24' | 0,790 R | 1,621 R |

| pour le sixième conducteur | 137°18' | 0,831 R | 1,580 R |
| pour le septième conducteur | 132°42' | 0,872 R | 1,415 R |
| pour le huitième conducteur | 105°00' | 0,914 R | 1,374 R |

où R est le rayon du cylindre qui les porte.

5. Bobine selon la revendication 2. caractérisée en ce que les deux nappes sont directement superposées.

6. Bobine selon la revendication 4. caractérisée en ce que le rapport de dimension de la section des conducteurs vaut 3.2.

7. Bobine selon l'une quelconque des revendications 1 à 6. caractérisée en ce que la dimension du petit côté de la section est de l'ordre de 1 % du rayon du cylindre.

FIG_1

# FIG_3-a

# FIG_3-b

FIG_2

0225814

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 290 748 (CENTRE TECHNIQUE DES INDUSTRIES MECANIQUES) <br> * Page 4, ligne 1 - page 6, ligne 33 * | 1-3 | G 01 N 24/06 <br> H 01 F 7/20 |
| A | EP-A-0 152 588 (SIEMENS AG) <br> * Page 6, ligne 30 - page 9, ligne 36 * | 1,2,5 | |
| A | FR-A-2 557 351 (OXFORD MAGNET TECHNOLOGY LTD) <br> * Page 5, ligne 4 - page 6, ligne 23 * | 1,2,5 | |
| A | DE-A-1 946 059 (THE PERKIN-ELMER CORP.) <br> * Figures * | 3 | DOMAINES TECHNIQUES RECHERCHES (Int. Cl.4) |
| A | US-A-4 509 030 (GENERAL ELECTRIC CO.) | | G 01 N 24/00 <br> H 01 F 5/00 <br> H 01 F 7/00 |
| D,A | EP-A-0 073 402 (SIEMENS AG) | | |

Le présent rapport de recherche a été établi pour toutes les revendications

| Lieu de la recherche | Date d'achèvement de la recherche | Examinateur |
|---|---|---|
| LA HAYE | 28-01-1987 | VANHULLE R. |